Europäisches Patentamt

European Patent Office

Office européen des brevets

(19)

(11) **EP 0 359 370 B1**

(12) # EUROPEAN PATENT SPECIFICATION

(45) Date of publication and mention
of the grant of the patent:
**03.01.1996 Bulletin 1996/01**

(51) Int Cl.6: **G03B 42/02**, G21K 1/04,
H05G 1/36, G03F 7/20,
G03B 9/00

(21) Application number: **89307230.6**

(22) Date of filing: **17.07.1989**

(54) **Exposure control in X-ray exposure apparatus**

Belichtungssteuerung in einem Röntgenbelichtungsapparat

Dispositif de contrôle d'exposition dans un appareil d'exposition à rayons X

(84) Designated Contracting States:
**DE FR GB NL**

(30) Priority: **14.09.1988 US 244410**

(43) Date of publication of application:
**21.03.1990 Bulletin 1990/12**

(73) Proprietor: **CANON KABUSHIKI KAISHA**
**Tokyo 146 (JP)**

(72) Inventors:
• **Ebinuma, Ryuichi**
**Kawasaki-shi, Kanagawa-ken (JP)**
• **Mizusawa, Nobutoshi**
**Yamatao-shi, Kanagawa-ken (JP)**

• **Suzuki, Masayuki**
**Zama-shi, Kanagawa-ken (JP)**
• **Uno, Shinichiro**
**Hadano-shi, Kanagawa-ken (JP)**
• **Mori, Tetsuzo**
**Atsugi-shi, Kanagawa-ken (JP)**
• **Kurosawa, Hiroshi**
**Atsugi-shi, Kanagawa-ken (JP)**

(74) Representative:
**Beresford, Keith Denis Lewis et al**
**London WC1R 5DJ (GB)**

(56) References cited:
**EP-A- 0 083 394      EP-A- 0 357 425**

• **PATENT ABSTRACTS OF JAPAN vol. 5, no. 179 (E-82)(851) 17 November 1981 & JP-A-56 104 438**

## Description

This invention relates to exposure control in an exposure apparatus for use in the manufacture of semiconductor microcircuits. More particularly, the invention is concerned with exposure control suitably usable in an X-ray exposure apparatus, for example, for exposing a mask and a wafer with a radiation (X-rays) from a synchrotron or otherwise to print a pattern of the mask upon the wafer.

In prior art X-ray exposure apparatuses, the amount of exposure is controlled in the following manner:

(1) From the sensitivity, to X-rays used, of a radiation-sensitive material (called a "resist") applied to a wafer and from the illuminance in the field of irradiation of the X-rays from a source (the illuminance being determined experientially), the exposure time for the whole irradiation field on the wafer is determined.

(2) An alternative is such that, as disclosed in Japanese Laid-Open Patent Application, Laid-Open No. Sho 60-198726, an X-ray detector is provided in the X-ray irradiation field and, while taking into account the variation in the X-ray illuminance with time, the exposure time for the whole irradiation field is determined.

In these prior art examples, the exposure time is determined uniformly over the whole of the irradiation field or an exposure region on a wafer. This involves a problem that, where there is non-uniformness in illuminance within the exposure region on the wafer, it is difficult to assure correct exposure throughout the exposure region. This causes inconveniences. For example, in X-ray lithography wherein a pattern of a linewidth of an order of 0.25 micron may be printed, it is possible that a semiconductor device formed on a wafer does not operate with a desired performance.

The non-uniformness in illuminance may be reduced by placing a radiation source far remote from a mask and a wafer. With this method, however, the illuminance itself within the whole exposure region on the wafer is reduced.

There is also disclosed in "Die Wissenschaftliche und Angewandte Photographie" 2nd vol., pp. 171-181; auth. Kurt Michel, ed. Springer-Verlag, Wien 1962, a camera which has a shutter in the form of a movable belt having an exposure aperture, the speed of the belt being variable in order to change the exposure time. However this prior art is concerned with correcting the exposure of the background of a photograph and is not concerned with the problem addressed by the present invention.

JP-A-56 104 438 discloses an apparatus for exposing a mask and a wafer, including a radiation source generating radiation having a non-uniform energy distribution along a predetermined one dimensional direction and a shutter movable along said direction, means for controlling movement of said shutter so as to make uniform the amount of radiation absorbed by the wafer; wherein the displacement profile includes acceleration and deceleration within the exposure region.

A further exposure system is disclosed in EP-A-0 357 425, which corresponds to an earlier application published after the priority date of the present application and is cited here under Art. 54(3) EPC.

An exposure apparatus and method according to the present invention are defined in claims 1 and 3.

In either the apparatus and method defined above the movable shutter is provided by a two-belt structure to achieve uniform exposure.

Preferably the radiation source comprises a synchrotron orbitration radiation ring.

How the invention may be carried out will now be described by way of example only and with reference to the accompanying drawings in which:

In the accompanying drawings:-

Figure 1 is a principle view schematically showing the basic components of an X-ray exposure system adapted according to an embodiment of the present invention.

Figure 2 is a schematic view of an illumination system using a synchrotron radiation.

Figure 3 is a fragmentary perspective view showing an example of a shutter device usable included for the purpose of reference.

Figure 4 is a schematic view showing the motion of a movable aperture member of the shutter device of the Figure 3 example.

Figure 5 is a fragmentary schematic view showing an example of a shutter device according to the present invention and usable in the Figure 1 embodiment.

Figure 6 is a graph showing an illuminance distribution provided by the illumination system of the Figure 2 example.

Figure 7 is a graph showing the action of the movable aperture member shown in Figure 3.

Figure 8 is a graph showing a distribution of exposure time in the example of Figure 7.

Figure 9 is a graph showing a distribution of exposure as defined in accordance with the exposure time distribution of the Figure 8 example.

Figure 10 is a graph showing idealistic motion of the movable aperture member shown in Figure 3

Figure 11 is a graph showing changes in the illuminance distribution with the change in the curvature (radius of curvature) of a cylindrical mirror of the illumination system of the Figure 2 example.

Figure 12 is a graph showing an optimum value of the curvature (radius of curvature) of the cylindrical mirror.

## DESCRIPTION OF THE PREFERRED EMBODIMENTS

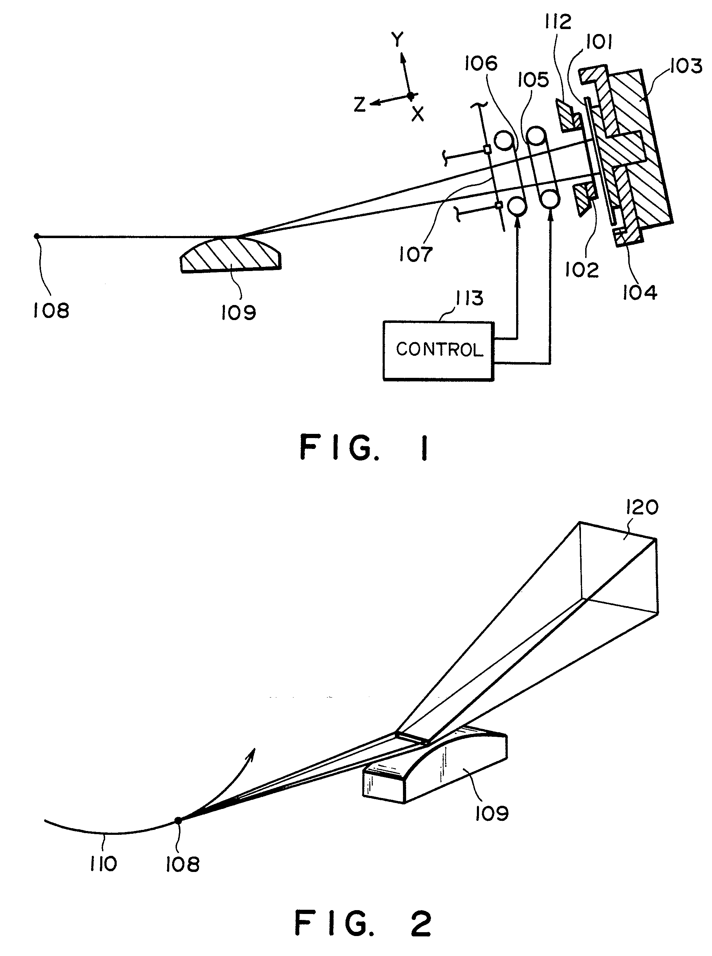

Referring first to Figure 1, there is shown a major portion of an X-ray exposure apparatus to which the present invention is applied. In Figure 1, a wafer 101 has a surface to which a radiation-sensitive material (resist) is applied. Mask 102 has formed thereon a pattern for manufacture of semiconductor devices. Mask stage 112 is adapted to hold the mask 102 in parallel to the wafer 101 with a clearance (mask-to-wafer gap) of about 40 microns in a Z-axis direction. Wafer moving stage 103 is adapted to hold the wafer 101 and to move the same in each of X-axis and Y-axis directions. The exposure apparatus of this embodiment is arranged such that, by means of the stage 103, different shot areas (exposure regions) of a wafer 101 are placed, in a predetermined order, to be opposed to an irradiation field 120 (see Figure 2), whereby the whole surface of the wafer 101 is exposed with radiation. At a time, a pattern bearing portion of the mask 102 and one exposure region of the wafer 101 are placed at the irradiation field 120. In other words, the exposure apparatus of this embodiment is structured as a step-and-repeat type exposure apparatus, called "stepper".

Sensor 104 is provided on the wafer moving stage 103 and is movable in the X and Y directions with the movement of the moving stage 103 so as to measure the illuminance at each of desired points in the irradiation field 120. Denoted generally at 105 is a main shutter mechanism having a movable aperture member. In this embodiment, the movable aperture member is provided by an endless belt having openings (apertures). The main shutter mechanism cooperates with an auxiliary shutter mechanism 106, to provide an exposure shutter device. The operation of each of the main shutter mechanism 105 and the auxiliary shutter mechanism 106 is controlled by a controller 113. More specifically, this controller 113 operates to control the main shutter mechanism 105, in a manner which will be described later, on the basis of the illuminance at each point within the irradiation field 120 as measured by use of the sensor 104. Also, the controller 113 operates to control the auxiliary shutter 106 so as to open the same before initiation of the exposure control by the main shutter mechanism 105 and to close the auxiliary shutter 106 after completion of the exposure control. Denoted at 107 is a beryllium thin film (partition film). The mask 102 side of this beryllium film 107 is maintained, for example, in a reduced-pressure He gas ambience, while a high-vacuum ambience is maintained on a radiation-source side of the film 107.

Denoted at 108 is a radiation emitting point of a synchrotron orbitration radiation (SOR) ring which functions as an X-ray source. The synchrotron radiation (X-rays) from the emission point 108 has a uniform intensity distribution in a direction (X-direction in this embodiment) parallel to the orbital plane of an electron beam 110 (see Figure 2), but has a substantially symmetric intensity distribution with respect to a direction (Y direction) perpendicular thereto.

As best seen in Figure 2, a convex-surface cylindrical mirror 109 functions to expand the synchrotron radiation from the emission point 108 in the direction (Y direction) in which the radiation has a substantially symmetric intensity distribution. The cylindrical mirror 109 is used to provide an irradiation field 120 of a required dimension, at the position at which the mask 102 and one exposure region of the wafer 101 are placed. Usually, when a cylindrical mirror whose reflection surface has a single curvature is used, there occurs in the irradiation field 120 a one-dimensional (Y direction) illuminance distribution (non-uniformness) having one peak. An example of such illuminance distribution is illustrated in Figure 6. The curve in Figure 6 has been drawn by plotting the results of calculation of the illuminance distribution as weighted in consideration of the dependency, upon wavelength, of the sensitivity of a resist material applied to a wafer 101. The axis of abscissa denotes the position while the axis of ordinate denotes specific illuminance in which the illuminance is standardized by using the illuminance $I_L$ or $I_U$ $(= I_L)$ at the position $Y_1$ or $Y_N$ as a reference $(= 1)$. Reference character $I_P$ denotes a peak illuminance, and reference character $Y_P$ denotes the position in the Y direction corresponding to the peak $Y_P$.

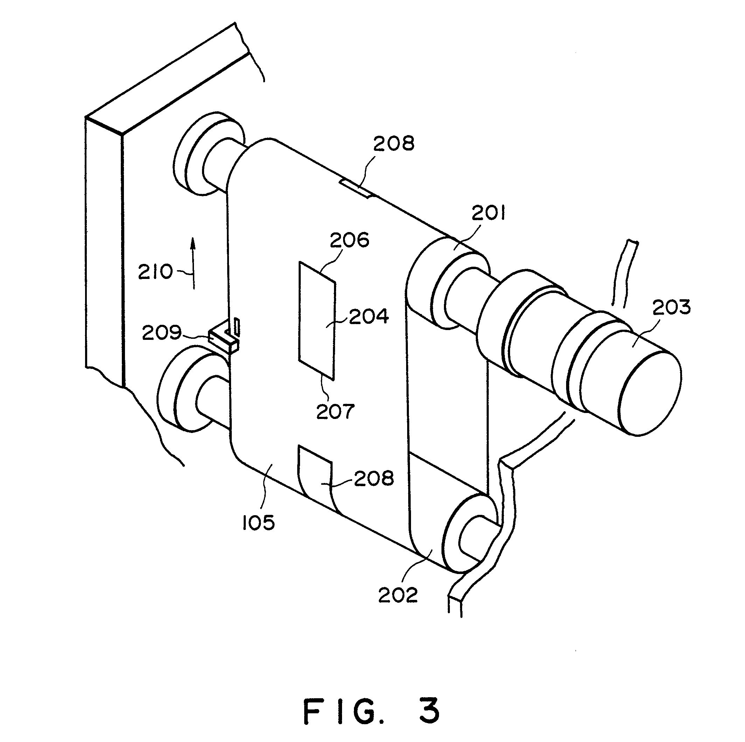

Figure 3 exemplifies a specific structure of a main shutter mechanism usable in the Figure 1 embodiment. Belt 105 having an aperture 204 comprises a thin metal belt made of a stainless steel, for example. This thin metal belt has a thickness sufficient for intercepting X-rays from the source.

The belt 105 is wound around rollers 201 and 202. By rotating one of these rollers by a driving motor 203, the aperture 204 of the belt 105 can operate as a movable aperture. Arrow 210 corresponds to the Y direction and denotes in Figure 3 the direction of movement of the aperture 204 which direction is coincident with the direction in which the synchrotron radiation has non-uniformness in intensity. The belt 105 is provided with two apertures one of which is denoted at 204 and another of which is denoted at 208. The aperture 204 functions as a movable aperture which is operable to locally control, along the Y direction, the exposure time for the exposure region. The aperture 204 has a leading edge 206 and a trailing edge 207. When the leading edge and the trailing edge of the aperture 204 moves through the exposure region in the Y direction, their moving speeds are controlled independently by the controller 113. The other aperture 208 is defined by an opening of a size and shape necessary for avoiding interception of the radiation from the source in a time period in which the movable aperture member provided by the opening 204 is in an open state.

Photosensor 209 is operable to detect the position of the aperture 204 and is used to determine the timing of passage of the aperture 204 through the exposure region.

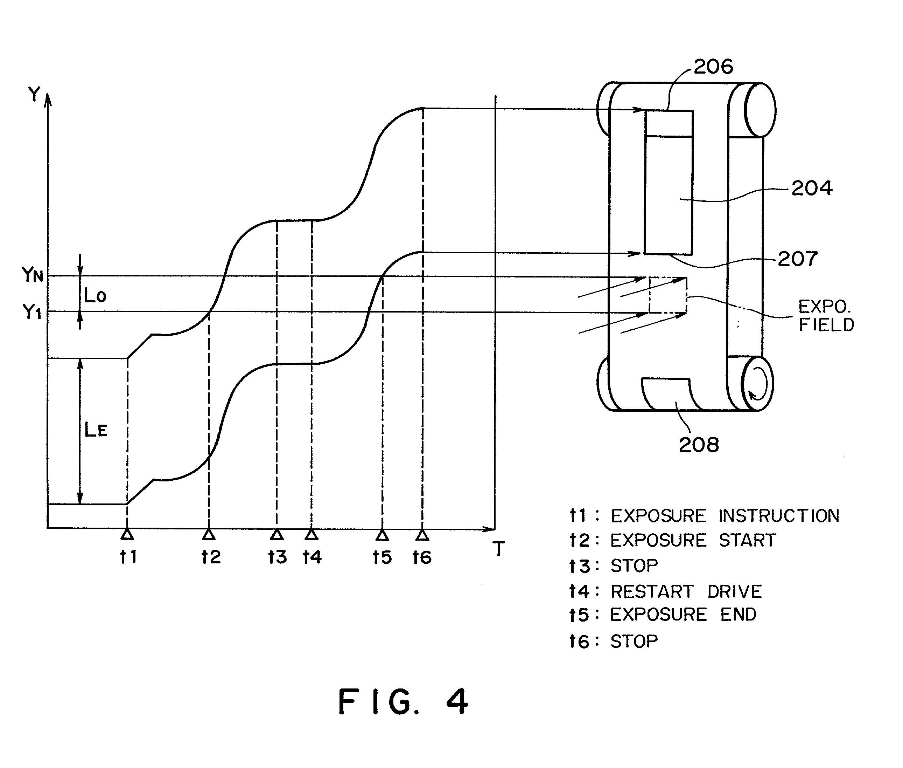

Figure 4 exemplifies the manner of movement of the leading edge 206 and the trailing edge 207 of the aperture 204 (movable aperture). In Figure 4, the axis of abscissa denotes the time and the axis of ordinates denotes the position of the movable aperture in its moving direction, namely, the position coordinate in the direction of non-uniformness in intensity of the radiation being projected. The zone as depicted at $L_O$ (from $Y_1$ to $Y_N$) corresponds to the exposure region (irradiation field) in Figure 4, reference character $L_E$ denotes the interval between the leading edge 206 and the trailing edge 207 of the aperture 204 in the Y direction. It is an important feature that, within the exposure region $L_O$, the moving speeds of the leading edge 206 and the trailing edge 207 change independently of each other. In an initial state, the aperture 204 is located at a position under the exposure region (exposure field), in Figure 4. When exposure start is instructed, the controller 113 operates to actuate the motor 203 to move the belt 105 with the cooperation of the rollers 202 and 203, so that the positions of the leading edge 206 and the trailing edge 207 of the aperture 204 are changed with the lapse of time along the curves shown in Figure 4. When the leading edge 206 reaches the position $Y_1$, the exposure starts. The leading edge 206 displaces between the positions $Y_1$ and $Y_N$ in such manner that the position of the leading edge 206 changes relatively slowly in the neighborhood of the position $Y_1$ whereas it changes relatively quickly in the neighborhood of the position $Y_N$. At this time, the trailing edge 207 has not reached the exposure region because there is a relationship "$L_O < L_E$". After this and when a middle portion of the aperture 204 reaches the exposure region, the controller 113 stops the drive of the motor 203 and, thereafter, restarts the drive of the motor 203 at a suitable timing. When the trailing edge 207 reaches the position $Y_N$, the exposure is completed, and, thereafter, the drive of the motor 203 is stopped. The trailing edge 207 displaces such that the position of trailing edge 207 changes relatively quickly in the neighborhood of the position $Y_1$, whereas it changes relatively slowly in the neighborhood of the position $Y_N$. The reason for controlling the moving speed (displacement) of each of the leading edge 206 and the trailing edge 207 will be explained later.

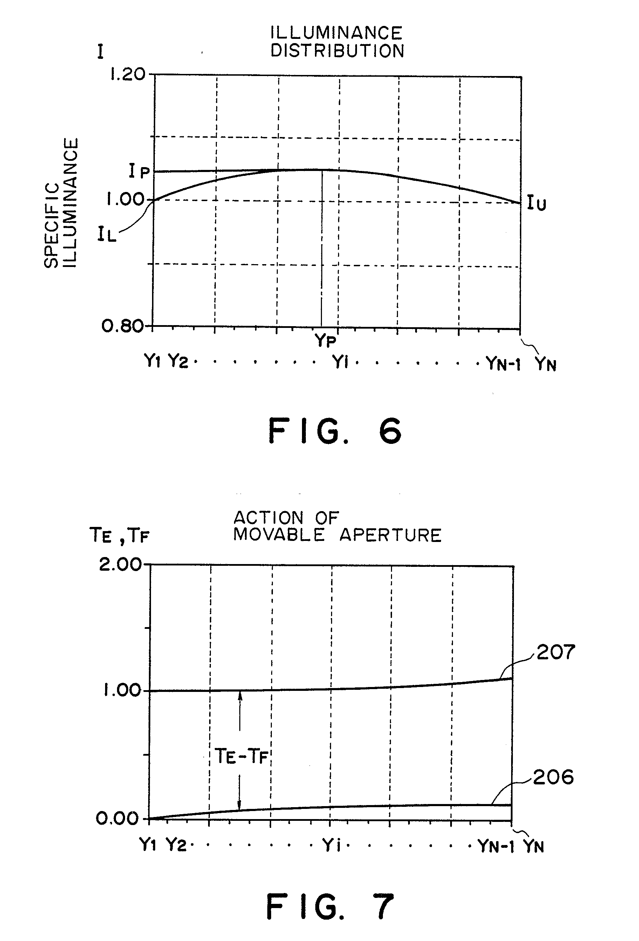

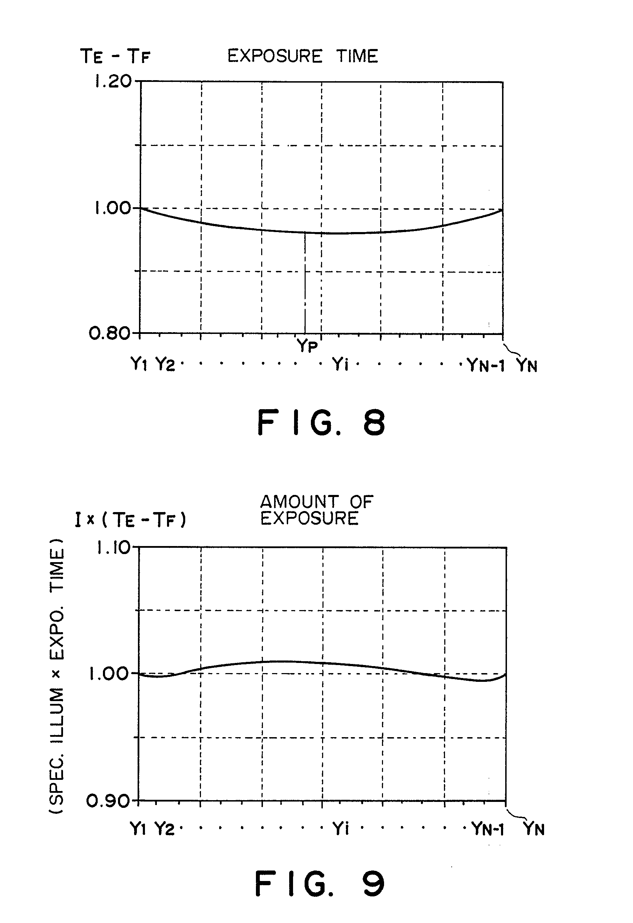

Figure 7 shows changes in the position of each of the leading edge 206 and the trailing edge 207, moving between the positions $Y_1$ and $Y_N$ in Figure 4. The axis of abscissa denotes the position coordinate in the Y direction, while the axis of ordinate denotes time. Figure 8 shows the exposure time ($T_E$ - $T_F$) at each point $Y_i$ between the positions $Y_1$ and $Y_N$. In these Figures, reference character $T_F$ denotes the time at which the leading edge 206 reaches the point $Y_i$, and reference character $T_E$ denotes the time at which the trailing edge 207 passes the point $Y_i$. It is seen from Figure 8 that, in the Figure 4 example, the exposure time is shorter at the central portion of the exposure region (zone between $Y_1$ and $Y_N$) than that at marginal portions.

In Figure 9, the illustrated curve shows the illuminance at each point $Y_i$ (Figure 6) as multiplied by the exposure time at each point $Y_i$ (Figure 8). Namely, the graph of Figure 9 shows the amount of exposure at each point $Y_i$ within the exposure region (actually, this corresponds to the amount of radiation absorbed by a resist material). It is seen from Figure 9 that, by the provision of a speed-controlled movable aperture of the present embodiment, the amount of exposure can be made substantially uniform throughout the exposure region irrespective of that the radiation contains non-uniformness as shown in Figure 6.

In the above-described example, the movable aperture moves through the exposure region by a constant acceleration motion. To be exact, accordingly, the amount of exposure in the exposure region is not completely uniform. However, depending on the manner of control of the movable aperture, it is in principle possible to make the amount of exposure completely uniform, over every point $Y_i$.

An example of this will be described below in detail.

Let's assume that, within the exposure region, a coordinate is set in the direction in which the illuminance changes. Points in the exposure region of a number N are selected and reference characters $Y_1$, $Y_2$, ... and $Y_n$ are assigned to these points.

Actual illumination intensity at a position $Y_i$, as calculated on the basis of the data obtained by the measurement by the sensor 104 and having been weighted in accordance with the sensitivity-to-wavelength characteristics of a resist material on a wafer, is denoted by $I_i$. Assuming that the required amount of exposure is E, then a correct exposure time at the position $Y_i$ in the exposure region can be expressed as follows:

$$T_i = E/I_i \tag{1}$$

On the other hand, the time at which the leading edge 206 of the movable aperture passes the point $Y_i$ is denoted by $T_{Fi}$ ($P_1$, $P_2$, ...). These reference characters $P_1$, $P_2$, ... are parameters for controlling the operation of the movable aperture. Similarly, the time at which the trailing edge 207 of the movable aperture passes the point $Y_i$ is denoted by $T_{Ei}$ ($P_1$, $P_2$, ...).

For each parameter $P_k$, such one by which the value E, determined by the following equation, becomes minimum is determined by calculation:

$$E = \partial \sum_i (T_{Ei} - T_{Fi} - T_i)^2 \qquad \ldots (2)$$

The motion of the movable aperture is controlled accordingly.

By doing so, it is possible to reduce to the minimum the error caused in relation to the control of the movable aperture.

If control parameters of a number not less than N are set, it is possible to establish the following relationship with respect to each point $Y_i$ on the exposure region:

$$T_{Ei} - T_{Fi} - T_i = 0 \qquad (3)$$

In this case, it is possible to provide the same amount of exposure at every point $Y_i$ in the exposure region. Therefore, it is possible to assure, at high precision, uniform exposure over the whole exposure region.

Taking this case as an example, a moving method by which the exposure can be completed in a shortest time will be explained below.

It is assumed now that $Y_1$ and $Y_N$ denote the ends of the exposure region; the movable aperture is moved in the direction from the point $Y_1$ to the point $Y_N$; an illuminance distribution such as shown in Figure 6 is provided; $I_P$ denotes the peak of the illuminance distribution in the exposure region; $Y_P$ denotes the position which provides the peak; $I_L = I_1$; and $I_U = I_N$.

In an example where, as shown in Figure 4, the movable aperture is provided by one endless belt having an aperture 204, and if the length $L_E$ of the aperture satisfies the following relation:

$$L_E \geqq \max(|Y_P - Y_1|, |Y_N - Y_P|),$$

then, the movable aperture may be moved in the manner that the time $T_{Fi}$ and the time $T_{Ei}$ at which each point $Y_i$ is passed by the leading edge 206 and the trailing edge 207 of the aperture 204, with a maximum speed Vmax of the movable aperture, can be expressed by the following equations:

1)

$$Y_i \leqq Y \leqq Y_P$$

$$T_{Fi} = T_{F0} = E/I_L - T_i + (Y_i - Y_1)/Vmax \qquad (4)$$

$$T_{Ei} = T_{Fi} + T_i \qquad (5)$$

2)

$$Y_P \leqq Y \leqq Y_N$$

$$T_{Fi} = T_{F0} + E/I_L - E/I_P + (Y_i - Y_1)/Vmax \qquad (6)$$

$$T_{Ei} = T_{Fi} + T_i \qquad (7)$$

wherein $T_{F0}$ is the time at which the leading edge 206 passes the point $Y_1$ ($T_{F1} = T_{F0}$).

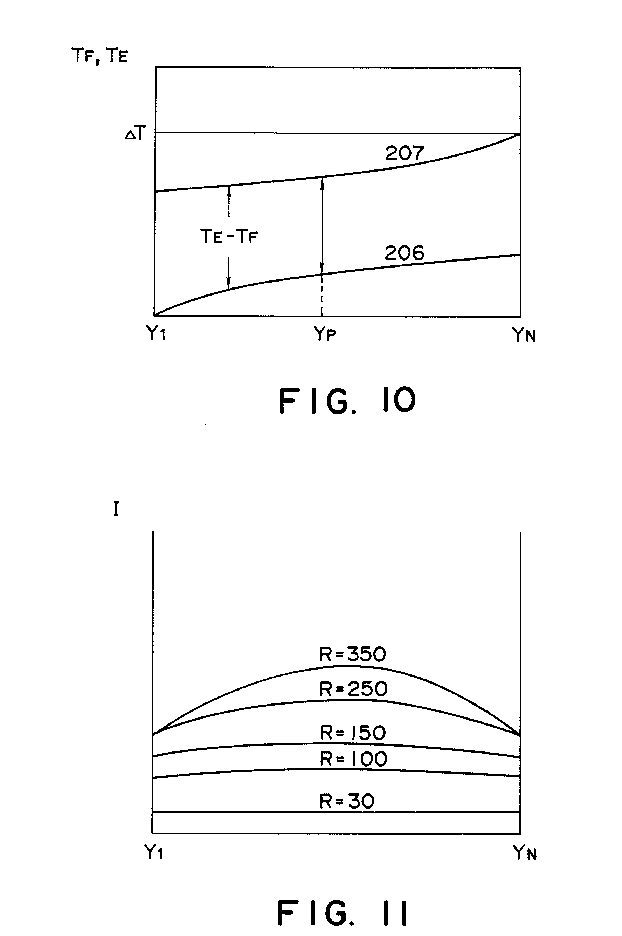

The manner of motion of the leading edge 206 and the trailing edge 207 as determined by equations (4), (5), (6) and (7) is shown in Figure 10. Also, in this example, like the Figure 7 example, the leading edge 206 displaces relatively slowly in the neighborhood of the point $Y_1$. The moving speed gradually increase and, in the neighborhood of the position $Y_N$, the leading edge moves relatively quickly. On the other hand, the trailing edge 207 moves relatively quickly in the neighborhood of the position $Y_1$ and the moving speed gradually decrease, such that the trailing edge moves relatively slowly in the neighborhood of the position $Y_N$. Also, the exposure time ($T_{Ei} - T_{Fi}$) in the exposure region is shortest at the position $Y_P$.

In this case, the time period $\Delta T$ from the entrance of the leading edge 206 of the aperture 204 into the exposure region to the exit of the trailing edge 207 of the aperture 204 from the exposure region is given by the following equation:

$$\Delta T = T_{EN} - T_{F1}$$

$$= E/I_L - E/I_P + T_N + (Y_N - Y_1)/Vmax$$

$$= E/I_L - E/I_P + E/I_U + L_0/Vmax \qquad (8)$$

Among various types of the motion of the movable aperture, satisfying equation (3), the above-described is the one that provides the minimum of the time ($\Delta T$).

Particularly, where $L_O \leq L_E$, the leading edge 206 and the trailing edge 207 do not exist in the exposure region at the same time. Therefore, the maximum speed Vmax can be determined as desired within a range of $E/I_L > L_O/Vmax$.

The motion according to equations (4) to (7) provides a minimum time $\Delta T$. However, it should be noted that the motion represented by these equations is not the sole solution. Any motion may be adopted, provided that equations (5) and (7) are satisfied.

Further, according to another important feature of the present invention, as long as the illuminance distribution is continuous, uniform exposure is attainable with regard to any illuminance distribution.

Equations (4) to (7) show one solution for such a moving method.

Namely, the leading edge 206 may be moved in accordance with equation (4) in such region wherein $T_i$ decreases in the moving direction, whereas the leading edge may be moved in accordance with equation (6) in such region wherein $T_i$ increases.

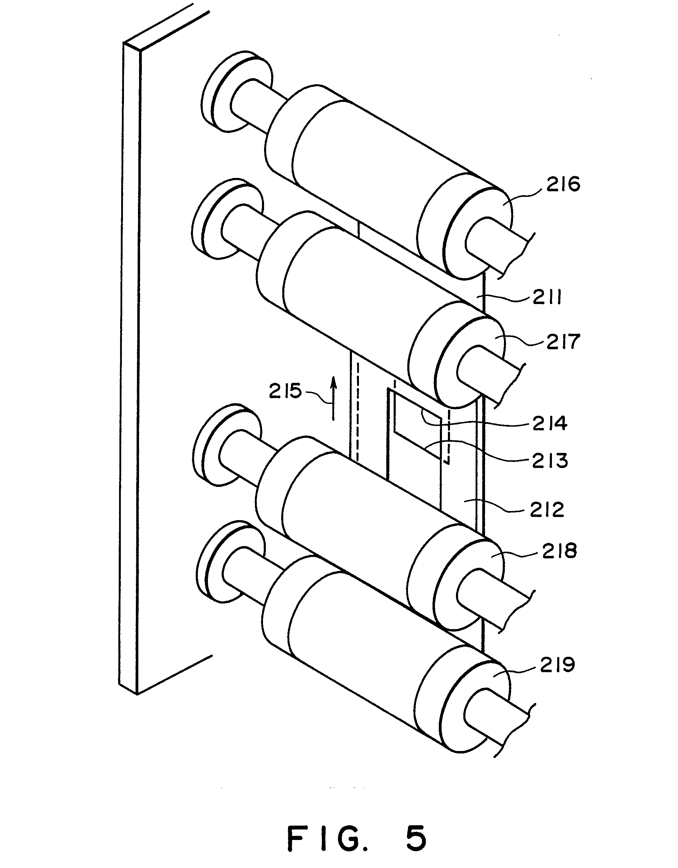

Referring now to Figure 5, an embodiment of a shutter device will according to the present invention be described.

Denoted in Figure 5 at 211 and 212 are two separate movable aperture members each being in the form of a belt member, in this embodiment. The movable aperture member 211 is wound around driving rollers 216 and 219, while the other aperture member 212 is wound around driving rollers 217 and 218. Arrow 215 denotes the moving direction of these aperture members for the exposure control.

In this embodiment, the origin sensor and the driving actuator of the Figure 3 embodiment are omitted. Reference numeral 214 denotes an edge of an opening of the aperture member 212, and this edge has a function substantially the same as that of the leading edge 206 of the Figure 3 embodiment. Reference numeral 213 denotes an edge of an opening of the aperture member 211, and this edge has a function substantially the same as that of the trailing edge 207 of the Figure 3 embodiment.

Where the leading edge and the trailing edge of a shutter device is provided by two separately movable members, as in the present embodiment, an auxiliary shutter member such as at 106 in Figure 1 may be omitted.

Further, in the present embodiment, the length $L_E$ of the opening in the Figure 4 example can be made apparently variable. Therefore, a higher degree of freedom is provided in respect to the control.

In the extension of the method of the present invention, which assures uniform exposure by use of movable aperture means, equation (8) provides an optimization method for the design of the illumination system shown in Figure 2. This will be described below in greater detail.

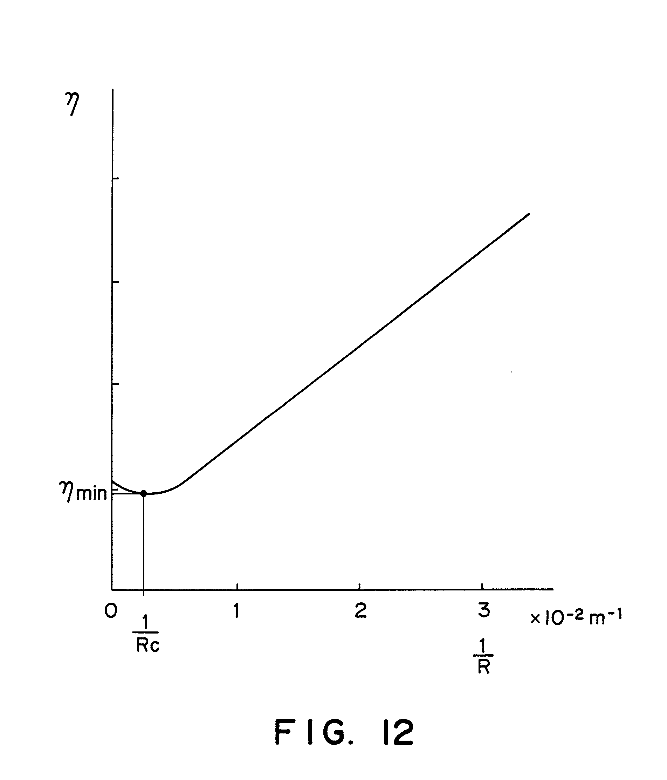

Figure 11 shows the illuminance distribution in the exposure region which varies with the change in the curvature 1/R of the convex-surface cylindrical mirror 109 of the illumination system shown in Figure 2.

In the particular example shown in Figure 11, calculations were made under the conditions that: the critical wavelength $\lambda_L$ of the synchrotron radiation was 10.2 Å; the intrinsic diversive angle σ at the critical wavelength $\lambda_L$ was 0.44 mrad; the distance between the emission point 108 of the synchrotron radiation and the reflection center of the mirror 109 was about 5 m; the distance between the reflection center of the mirror 109 and the movable aperture 105 was about 7 m; and the size $L_O$ of the exposure region in the Y direction was about 30 mm (the Y direction is substantially vertical, although the inclination is emphasized in Figure 1). Under these conditions and while taking into account the angle of incidence of the radiation upon the mirror 109, the calculations were made.

Figure 12 is a graph wherein the axis of abscissa denotes 1/R while the axis of ordinate denotes η which, in an occasion where the movable aperture means is moved in accordance with equations (4) to (7), can be expressed by the following equation (9):

$$\eta = 1/l_U + 1/l_L - 1/l_P \tag{9}$$

$$\Delta T = \eta E + L_0/Vmax \tag{10}$$

As seen in this Figure, there exists such a radius of curvature (Rc) of the convex-surface cylindrical mirror 109 that provides the minimum of. While the value Rc is variable depending on the profile of the synchrotron radiation source and the size of the exposure field as well as the disposition of the radiation source, the mirror and the mask, for example, it is possible to assure an exposure system having a shortest opening time for the shutter and having a good efficiency with respect to time, by selecting, as the radius of curvature of the convex-surface cylindrical mirror, such an Rc that provides the minimum of η as represented by equation (9).

However, upon actual determination of the radius of curvature, the selection of Rc does not always provide a best result.

In the method of the present invention making the exposure uniform, error factors which affect the uniformization include an error in the measurement of illuminance, an error in the control of the moving speed of the movable aperture, and so on.

The tolerances for these errors are determined in respect to the required precision for the amount of exposure. Each error can be reduced more easily, with smaller non-uniformness in the intensity of radiation. This is in the tendency to reducing the radius of curvature of the cylindrical mirror and, therefore, increasing the exposure time. To enlarge the radius of curvature of the cylindrical mirror beyond Rc causes larger non-uniformness in the radiation and, additionally, the prolongation of the exposure time. Therefore, to do so provides no merit.

As will be understood from the above, it is desirable to take the value Rc as an upper limit for the radius of curvature of the cylindrical mirror and to select a smaller radius of curvature within a range that does not increase the exposure time beyond a tolerable level.

When the radius R is small, on the other hand, the non-uniformness in the intensity of radiation becomes small and the effectiveness of the present invention, uniformizing the exposure by the action of the movable aperture means, may be reduced. But the illuminance itself becomes too low. In consideration of this, where the radius of curvature of the cylindrical mirror that provides the minimum $\eta$min is denoted by Rc, the radius R may desirably be within the limit of about 3 x $\eta$min.

In the particular example of Figure 12, the radius R = 30m defines an intensity distribution which provides "3.6 x $\eta$min".

In the foregoing embodiments, the motion of the movable aperture has been described with reference to an example where the illuminance distribution has one peak. However, as long as the illuminance distribution is one dimensional and the illuminance changes continuously, the present invention is applicable to any profile of distribution and assures uniformization of the exposure. Thus, the present invention is applicable not only to an illumination system having a cylindrical mirror but also to any other illumination system using any other optical component such as a non-cylindrical mirror, for example.

With regard to the illuminance distribution I, it may be measured after execution of actual exposure and development. Alternatively, it may be detected by calculations based on the ray tracing to the synchrotron radiation.

In accordance with the present invention, as described hereinbefore, a speed-controllable movable aperture means is provided, as an exposure shutter, in an exposure apparatus having an illumination system which provides a radiation containing non-uniformness in the illuminance within an exposure field, and the aperture means is controlled to locally control the exposure time. By this, the non-uniformness in the amount of exposure (the amount of radiation absorbed by the resist material) resulting from the non-uniformness in the illuminance can be reduced remarkably, with the result that the resolution of the exposure apparatus can be improved significantly.

Further, since the precision itself for the uniformness in the exposure as required from the point of resolution in the exposure process can be satisfied by the local exposure time control of the present invention using the movable aperture means, the tolerance for the non-uniformness in illuminance as can be set for the illumination system side is determined by the performance of this local exposure time control, and a significantly wider tolerance is allowed as compared with those for the non-uniformness as allowed conventionally.

Usually, the magnitude of the illuminance and the uniformness thereof are somewhat incompatible factors in respect to the design of an illumination system. Therefore, if the tolerance for the non-uniformness becomes wider, as in the present invention, the illuminance can be made higher correspondingly. This makes it possible to reduce the exposure time and to reduce the exposure error due to the variation with time during the exposure. Additionally, this makes it possible to increase the processing speed of the apparatus, called "throughput".

In the foregoing, it is showed that an exposure apparatus according to the present invention having two movable aperture means, can accomplish more precise and correct exposure even when it is used with an illumination system that provides a much higher intensity of illumination than those of prior art illumination systems. By using the exposure time as an evaluation function, an index is given in the optimum designing of an illumination system.

**Claims**

1. An exposure apparatus for exposing a mask (102) and a wafer (101) with radiation energy to transfer a pattern of the mask onto an exposure region of the wafer, said apparatus including a radiation source (108) for generating radiation energy with a predetermined non-uniform intensity distribution along a predetermined direction, and a movable shutter comprising two movable members (105, 106) movable along said predetermined direction, wherein one movable member (105) has a leading edge portion (206) effective to start exposure of the exposure region of the wafer to the radiation energy and the other movable member (106) has a trailing edge portion (207) effective to finish the exposure of the exposure region to the radiation energy, control means (113) for controlling said movable shutter so as to make substantially uniform the amount of radiation energy absorbed by a resist on the wafer in the exposure region; said leading edge portion and said trailing edge portion of said movable members passing through the exposure region with different displacement profiles each corresponding to the intensity distribution of the radiation energy in the direction of movement of the movable member, said displacement profiles each including at least one of acceleration and deceleration within the range of the exposure region, wherein

   said control means (113) is adapted to control the speed of the movable member whereby the apparatus satisfies one of the following conditions: (i) both the leading edge and the trailing edge are not present within the exposure region at the same time, and (ii) the relation:-

$$L_E \geq \max (|Y_P - Y_1|, |Y_N - Y_P|),$$

when the first condition is not satisfied, wherein, measured along said predetermined direction, $L_E$ is the distance between said leading edge and said trailing edge, $Y_1$ is the coordinate position of an end of the exposure region, $Y_N$ is the coordinate position of the other end of the region, and $Y_P$ is the coordinate position of a peak illuminance in the exposure region.

2. An apparatus according to Claim 1, wherein said radiation source comprises a synchrotron orbitation radiation ring.

3. An exposure method of exposing a mask (102) and a wafer (101) with radiation energy to transfer a pattern of the mask onto an exposure region of the wafer, by using a radiation source (108) for generating radiation energy with a predetermined non-uniform intensity distribution along a predetermined direction, and a movable shutter comprising two movable members (105, 106) movable along said predetermined direction, wherein one movable member (105) has a leading edge portion (206) effective to start exposure of the exposure region of the wafer to the radiation energy and the other movable member (106) having a trailing edge portion (207) effective to finish the exposure of the exposure region to the radiation energy, said movable shutter being controlled so as to make substantially uniform the amount of radiation energy absorbed by a resist on the wafer in the exposure region; said leading edge portion and said trailing edge portion of the movable members passing through the exposure region with different displacement profiles each corresponding to the intensity distribution of the radiation energy in the direction of movement of the movable member, said displacement profiles each including at least one of acceleration and deceleration within the range of the exposure region, the method including the step of

controlling the speed of movable member belts whereby the opening defined by the distance between the leading and trailing edge portions satisfies one of the following conditions: (i) both the leading edge and trailing edge are not present within the exposure region at the same time and (ii) the relation:-

$$L_E \geq \max (|Y_P - Y_1|, |Y_N - Y_P|),$$

when the first condition is not satisfied, wherein, measured along said predetermined direction, $L_E$ is the distance between said leading edge and said trailing edge, $Y_1$ is the coordinate position of an end of the exposure region, $Y_N$ is the coordinate position of the other end of the region and $Y_P$ is the coordinate position of a peak illuminance in the exposure region.

**Patentansprüche**

1. Belichtungsvorrichtung zur Belichtung einer Maske (102) und eines Wafer (101) mit Strahlungsenergie, um ein Muster der Maske auf einen Bereich der Belichtung auf den Wafer zu übertragen, wobei die Vorrichtung eine Strahlungsquelle (108) zur Erzeugung der Strahlungsenergie mit einer vorbestimmten nicht gleichförmigen Intensitäts-Verteilung entlang einer vorbestimmten Richtung umfaßt, sowie einen bewegbaren Verschluß umfaßt, der zwei bewegbare Bauteile (105, 106) aufweist, die entlang der vorbestimmten Richtung bewegbar sind, wobei ein bewegbares Bauteil (105) eine führende Kante (206) aufweist, die wirksam ist, um die Belichtung des Belichtungs-Bereiches des Wafer mit der Strahlungsenergie zu beginnen und wobei das andere bewegbare Bauteil (106) eine Hinterkante (207) aufweist, die wirksam ist, um die Belichtung des Belichtungs-Bereiches mit der Strahlungsenergie zu beenden, und eine Steuerung (113) zur Steuerung des bewegbaren Verschlußes umfaßt, um so die Menge an Strahlungsenergie im westlichen gleichmäßig zu machen, die durch einen Abdecklack auf dem Wafer in dem Belichtungs-Bereich absorbiert wird; wobei die führende Kante und die Hinterkante der bewegbaren Bauteile den Belichtungs-Bereich mit unterschiedlichen Verschiebungs-Profilen durchlaufen, wobei jedes Profil der Intensitäts-Verteilung der Strahlungsenergie in der Richtung der Bewegung der bewegbaren Bauteile entspricht, und wobei jedes der Verschiebungs-Profile zumindest eine Beschleunigung und eine Verzögerung innerhalb des Bereiches des Belichtungs-Bereiches umfaßt, wobei

die Steuerung (113) angepaßt ist, um die Geschwindigkeit des bewegbaren Bauteils zu steuern, wobei die Vorrichtung eine der folgenden Bedingungen erfüllt: (i) beide, die führende Kante und die Hinterkante sind zur gleichen Zeit nicht innerhalb des Belichtungs-Bereiches anwesend, und (ii) die Relation:

$$L_E \geq \max (|Y_P - Y_1|, |Y_N - Y_P|),$$

falls die erste Bedingung nicht erfüllt ist, wobei $L_E$ der Abstand zwischen der führenden Kante und der Hinterkante ist, gemessen entlang der vorbestimmten Richtung, $Y_1$ die Koordinaten-Position eines Endes des Belichtungs-Bereiches ist, $Y_N$ die Koordinaten-Position des anderen Endes des Bereiches ist, und $Y_P$ die Koordinaten-Position einer Spitzen-Beleuchtungsstärke in dem Belichtungs-Bereich ist.

2. Vorrichtung nach Anspruch 1, wobei die Strahlungsquelle einen Synchrotron-Orbital-Strahlungs-Ring umfaßt.

3. Belichtungsverfahren zur Belichtung einer Maske (102) und eines Wafer (101) mit Strahlungsenergie, um ein Muster der Maske auf einen Bereich der Belichtung auf den Wafer zu übertragen, indem eine Strahlungsquelle (108) zur Erzeugung der Strahlungsenergie mit einer vorbestimmten nicht gleichförmigen Intensitäts-Verteilung entlang einer vorbestimmten Richtung eingesetzt wird, sowie ein bewegbarer Verschluß, der zwei bewegbare Bauteile (105, 106) aufweist, die entlang der vorbestimmten Richtung bewegbar sind, wobei ein bewegbares Bauteil (105) eine führende Kante (206) aufweist, die wirksam ist, um die Belichtung des Belichtungs-Bereiches des Wafer mit der Strahlungsenergie zu beginnen und wobei das andere bewegbare Bauteil (106) eine Hinterkante (207) aufweist, die wirksam ist, um die Belichtung des Belichtungs-Bereiches mit der Strahlungsenergie zu beenden, wobei der bewegbare Verschluß gesteuert wird, um so die Menge an Strahlungsenergie im westlichen gleichmäßig zu machen, die durch einen Abdecklack auf dem Wafer in dem Belichtungs-Bereich absorbiert wird; wobei die führende Kante und die Hinterkante der bewegbaren Bauteile den Belichtungs-Bereich mit unterschiedlichen Verschiebungs-Profilen durchlaufen, wobei jedes Profil der Intensitäts-Verteilung der Strahlungsenergie in der Richtung der Bewegung der bewegbaren Bauteile entspricht, und wobei jedes der Verschiebungs-Profile zumindest eine Beschleunigung und eine Verzögerung innerhalb des Bereiches des Belichtungs-Bereiches umfaßt, wobei das Verfahren folgende Schritte umfaßt:

Steuerung der Geschwindigkeit der bewegbaren Bauteil-Gurte, wobei die Öffnung, die als Abstand zwischen der führenden Kante und der Hinterkante definiert ist, eine der folgenden Bedingungen erfüllt: (i) beide, die führende Kante und die Hinterkante sind zur gleichen Zeit nicht innerhalb des Belichtungs-Bereiches anwesend, und (ii) die Relation:

$$L_E \geq \max(|Y_P - Y_1|, |Y_N - Y_P|),$$

falls die erste Bedingung nicht erfüllt ist, wobei $L_E$ der Abstand zwischen der führenden Kante und der Hinterkante ist, gemessen entlang der vorbestimmten Richtung, $Y_1$ die Koordinaten-Position eines Endes des Belichtungs-Bereiches ist, $Y_N$ die Koordinaten-Position des anderen Endes des Bereiches ist, und $Y_P$ die Koordinaten-Position einer Spitzen-Beleuchtungsstärke in dem Belichtungs-Bereich ist.

**Revendications**

1. Appareil d'exposition pour exposer un masque (102) et une plaquette (101) à une énergie de rayonnement pour transférer un motif du masque sur une région d'exposition de la plaquette, ledit appareil comportant une source (108) de rayonnement pour générer une énergie de rayonnement avec une répartition d'intensité non uniforme prédéterminée dans une direction prédéterminée, et un obturateur mobile comprenant deux éléments (105, 106) mobiles dans ladite première direction prédéterminée, dans lequel un élément (105) mobile présente une partie (206) de bord avant ayant pour effet de commencer l'exposition de la région d'exposition de la plaquette à l'énergie de rayonnement et l'autre élément (106) mobile ayant une partie (207) de bord arrière ayant pour effet de finir l'exposition de la région d'exposition à l'énergie de rayonnement, un moyen (113) de commande pour commander ledit obturateur mobile de façon à rendre sensiblement uniforme la quantité d'énergie de rayonnement absorbée par un vernis photosensible sur la plaquette dans la région d'exposition; ladite partie de bord avant et ladite partie de bord arrière desdits éléments mobiles passant dans la région d'exposition avec des profils de déplacement différents correspondant chacun à la répartition d'intensité de l'énergie de rayonnement dans la direction de mouvement de l'élément mobile, lesdits profils de déplacement comportant chacun au moins une accélération et une décélération dans le domaine de la région d'exposition, dans lequel

ledit moyen (113) de commande est conçu pour commander la vitesse de l'élément mobile afin que l'appareil réponde à l'une des conditions suivantes : (i) le bord avant et le bord arrière ne sont pas tous deux présents simultanément dans la région d'exposition, et (ii) la relation suivante doit être satisfaite :

$$L_E \geq \max(|Y_P - Y_1|, |Y_N - Y_P|),$$

lorsque la première condition n'est pas satisfaite, où $L_E$ est la distance, mesurée dans ladite direction prédéterminée, entre ledit bord avant et ledit bord arrière, $Y_1$ est la coordonnée d'une extrémité de la région d'exposition, $Y_N$ est la coordonnée de l'autre extrémité de la région, et $Y_P$ est la coordonnée d'un pic d'éclairement dans la région d'exposition.

2.  Appareil selon la revendication 1, dans lequel ladite source de rayonnement comprend un anneau de rayonnement orbital synchrotron.

3.  Procédé d'exposition pour exposer un masque (102) et une plaquette (101) à une énergie de rayonnement pour transférer un motif du masque sur une région d'exposition de la plaquette, en utilisant une source (108) de rayonnement pour générer une énergie de rayonnement avec une répartition d'intensité non uniforme prédéterminée dans une direction prédéterminée, et un obturateur mobile comprenant deux éléments (105, 106) mobiles dans ladite première direction, dans lequel un élément (105) mobile a une partie (206) de bord avant ayant pour effet de commencer l'exposition de la région d'exposition de la plaquette à l'énergie de rayonnement et l'autre élément (106) mobile ayant une partie (207) de bord arrière ayant pour effet de finir l'exposition de la région d'exposition à l'énergie de rayonnement, ledit obturateur mobile étant commandé de façon à rendre sensiblement uniforme la quantité d'énergie de rayonnement absorbée par un vernis photosensible sur la plaquette dans la région d'exposition, ladite partie de bord avant et ladite partie de bord arrière des éléments mobiles passant dans la région d'exposition avec des profils de déplacement différents correspondant chacun à la répartition d'intensité de l'énergie de rayonnement dans la direction de mouvement de l'élément mobile, lesdits profils de déplacement comportant chacun au moins une accélération et une décélération dans le domaine de la région d'exposition, le procédé comportant les étapes qui consistent :

    à commander la vitesse de courroies d'éléments mobiles afin que l'ouverture définie par la distance entre les parties de bord avant et arrière répondent à l'une des conditions suivantes : (i) le bord avant et le bord arrière ne doivent pas être tous deux présents dans la région d'exposition au même instant et (ii) la relation suivante doit être satisfaite :

$$L_E \geq \max(|Y_P - Y_1|, |Y_N - Y_P|),$$

    lorsque la première condition n'est pas satisfaite, où $L_E$ est la distance, mesurée dans ladite direction prédéterminée, entre ledit bord avant et ledit bord arrière, $Y_1$ est la coordonnée d'une extrémité de la région d'exposition, $Y_N$ est la coordonnée de l'autre extrémité de la région, et $Y_P$ est la coordonnée d'un pic d'éclairement dans la région d'exposition.

FIG. 1

FIG. 2

FIG. 3

t1 : EXPOSURE INSTRUCTION
t2 : EXPOSURE START
t3 : STOP
t4 : RESTART DRIVE
t5 : EXPOSURE END
t6 : STOP

# FIG. 4

EP 0 359 370 B1

216
211
217
215
214
213
212
218
219

# FIG. 5

FIG. 6

FIG. 7

F I G. 8

F I G. 9

F I G. 10

F I G. 11

FIG. 12